(19) **Europäisches Patentamt** / **European Patent Office** / **Office européen des brevets**

(11) **EP 2 985 910 A1**

(12) **EUROPEAN PATENT APPLICATION**

(43) Date of publication:
**17.02.2016 Bulletin 2016/07**

(51) Int Cl.:
**H03F 3/189** (2006.01)　　　**H03F 3/217** (2006.01)

(21) Application number: **14306277.6**

(22) Date of filing: **14.08.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ALCATEL LUCENT**
**92100 Boulogne-Billancourt (FR)**

(72) Inventors:
• **Markert, Daniel**
 **70435 Stuttgart (DE)**

• **Haslach, Christoph**
 **70435 Stuttgart (DE)**
• **Dartois, Luc**
 **70435 Stuttgart (DE)**
• **Wantiez, Eric**
 **70435 Stuttgart (DE)**

(74) Representative: **2SPL Patentanwälte PartG mbB**
**Postfach 15 17 23**
**80050 München (DE)**

Remarks:
Amended claims in accordance with Rule 137(2) EPC.

(54) **Apparatuses, methods and computer programs to provide information related to a pulse width modulated signal and to determine a look-up table**

(57)　Embodiments provide apparatuses, methods and computer programs to provide information related to a pulse width modulated signal and to determine a look-up table. An apparatus (10) to provide information related to a pulse width modulated signal for an amplifier comprises an input for a baseband signal, and a processing module (12) to determine an integrated value based on a corrected baseband signal and to determine a quantized value based on the integrated value. The corrected baseband signal is based on a former quantized value.

The processing module (12) is configured to select information on multiple pulses based on the quantized value and to provide information on the multiple selected pulses as information related to the pulse width modulated signal. An apparatus (20) to determine a look-up table to assign a quantized value to a sequence of pulses comprises a processing module (22) to determine individual quantization values for pulses of the sequence of pulses and to determine the quantized value based on the individual quantization values for the pulses of the sequence.

Fig. 3

**Description**

<u>Technical Field</u>

Embodiments relate to apparatuses, methods and computer programs to provide information related to a pulse width modulated signal and to determine a look-up table, more particularly but not exclusively, to a concept to generate a pulse width modulated signal as input for an amplifier.

<u>Background</u>

This section introduces aspects that may be helpful in facilitating a better understanding of the invention(s). Accordingly, the statements of this section are to be read in this light and are not to be understood as admissions about what is in the prior art or what is not in the prior art.

Demands for higher data rates for mobile services are steadily increasing. At the same time modem mobile communication systems as 3rd Generation systems (3G) and 4th Generation systems (4G) provide enhanced technologies, which enable higher spectral efficiencies and allow for higher data rates and cell capacities. The demands are growing for both directions of transmission, in the DownLink (DL) for transmission from the network infrastructure to a mobile transceiver, as well as in the UpLink (UL) for transmission from a mobile transceiver to the network infrastructure.

One aspect, which gains more and more attention, is the power efficiency of the system, both that of the infrastructure as well as of the user equipment. Contributors to power consumption of wireless transmitters are power amplifiers, which are used to amplify the radio frequency signal before transmission via one or more transmit antennas. Several concepts are known for such power amplifiers, for example, different amplifier concepts are distinguished for different classes of amplifiers.

Power amplifiers can be assigned to classes A, B, AB and C for analog implementations, and classes D, E, F and S for digital implementations, which may make use of switching concepts and which may promise higher power efficiencies. Basically, switching concepts may foresee to toggle one or more transistors between conducting and non-conducting states so to generate a power signal at the output, which accordingly varies between two states.

Some power amplifiers may use pulse-width modulated signals at their input, such that a time sequence of changing output levels (amplitude and phase) of the amplifier is reflected by pulse widths of the input signal. In some implementations the output signal may be fully switched on and off. Switch mode power amplifiers may be considered as promising approaches for future highly efficient and highly flexible transmitter and amplifier solutions. A key issue in this context may be the switch mode signal generation. One way to generate those signals is to combine Delta Sigma Modulation (DSM) and Pulse Width Modulation (PWM).

Further details can be found in WO 2014/079862 A1, EP 2 330 734 A1, EP 2 403 136 B1, and Bassoo, Vandana (2010), "A digital up-conversion architecture for future high efficiency wireless base stations", PhD thesis thesis, Victoria University.

<u>Summary of illustrative Embodiments</u>

Some simplifications may be made in the following summary, which is intended to highlight and introduce some aspects of the various exemplary embodiments, but such simplifications are not intended to limit the scope of the invention(s). Detailed descriptions of a preferred exemplary embodiment adequate to allow those of ordinary skill in the art to make and use the inventive concepts will follow in later sections.

Various embodiments provide apparatuses, methods and computer programs to provide information related to a pulse width modulated signal and to determine a look-up table, more particularly but not exclusively, to a concept to generate a pulse width modulated signal for an amplifier. As one challenge in such concepts it may be considered that a feedback loops may run at the carrier frequency in order to enable pulse pattern at a high enough rate. Embodiments may enable a reduction of a speed or cycle frequency of a feedback loop and may further enable reduced complexity in implementations. Embodiments may allow trading-off between linearity and efficiency of amplifier circuitry or amplifier signal generation. Thereby, the system may be improved/adapted to a given application or mode of operation. Conventional concepts may use feedback loops cycled at the carrier frequency and accordingly adapted fast technology and strict timings. Such fast operation may limit complexity of signal processing and memory access, the size of look-up tables, respectively, because delay could cause instability of the feedback loop, for example in a DSM. Embodiments may enable utilization of larger look-up tables or more complex operations in the feedback path.

Embodiments provide an apparatus to provide information related to a pulse width modulated signal for an amplifier. The apparatus comprises an input for a baseband signal. The apparatus further comprises a processing module to determine an integrated value based on a corrected baseband signal and to determine a quantized value based on the integrated value. The corrected baseband signal is based on a former quantized value. The processing module is configured to select information on multiple pulses based on the quantized value and is configured to provide information on the multiple selected pulses as information related to the pulse width modulated signal. Embodiments may allow selecting multiple pulses based on a quantized value such that the determination cycle for quantized values can be lower than a selection cycle per pulse for a pulse width modulated signal.

In some embodiments a plurality of quantized values is determined as a time discrete signal at a first rate and the information on the multiple pulses indicates pulses at a second rate. The first rate is lower than the second rate. Embodiments may allow operating a determination of quantized values at a lower rate than a pulse selection. In some embodiments the baseband signal may correspond to a time discrete signal at a third rate. The third rate may be lower than the first rate and the second rate. Embodiments may enable provision of a base band signal at a lower rate than a determination rate for quantized values based on which pulses are selected at a selection rate, which is even higher than the determination rate. Embodiments may enable an enhanced signal processing for the determination of the quantized values, as quantized values may be determined at a determination rate lower than a pulse selection rate, while baseband samples can be processed and provided at an even lower rate.

In some embodiments the processing module may be configured to assign a quantized value to a sequence of one or more integrated values or pulses and the sequence of integrated values or pulses may be based on a sequence of one or more corrected baseband values. The sequence of one or more corrected baseband values may be corrected based on the same quantized value. Embodiments may enable a sequence of baseband values to be processed based on the same quantized value, and a quantized value to be determined based on a sequence of one or more corrected baseband values. It is to be noted that in such embodiments the third rate, at which baseband samples are provided or input may be higher than the determination rate of the quantized values or the above first rate. Furthermore, the multiple selected pulses may comprise two or more repetitions of the same pulse. Embodiments may enable pulse repetition and therewith a reduction of a pulse selection cycle, a reduction of the determination rates for the quantized values, respectively.

The processing module may be configured to obtain the quantized value based on a look-up table. The look-up table may assign quantized values to different sequences of pulses and/or the look-up table may allow assigning the multiple pulses to the quantized value. Embodiments may use a look-up operation for the assignment operation between integrated values and quantized values, between quantized values and multiple pulses, respectively. In embodiments such look-up tables may be predetermined or updated based on a time scale or based on other criteria, such as error rate or power, amplifier efficiency, etc. In some embodiments the processing module may be configured to determine the look-up table based on a number of individual quantization values for a sequence of multiple pulses, wherein an individual quantization value represents a pulse in the sequence of multiple pulses, based on a number of different amplitude values distinguished per individual quantization value in the sequence, and based on a number of different phase values distinguished per individual quantization value in the sequence of pulses. In embodiments the look-up table may comprise a quantization value for different combinations of the quantized amplitudes and phases. The processing module may be configured to update the look-up table and/or to determine information related to improvement values for the look-up table based on an output signal of the amplifier. Embodiments may enable adaptive updating of the pulse selection based on feedback from the output of the amplifier.

In some embodiments the number of quantized values in the look-up table may be less than a number of permutations of individual quantization values. An individual quantization value represents a pulse of a sequence of pulses, for example in terms of an amplitude and a phase of a corresponding envelope signal of a radio signal. The number of permutations of individual quantization values is based on an increased product of the number of different amplitude values distinguished for individual quantization values and the number of different phase values distinguished for individual quantization values, wherein the product is increased by one and wherein the increased product is raised to the power of the number of pulses in the sequence of pulses. In some embodiments the look-up table may comprise a quantized value for all combinations of individual quantized values for the sequence of pulses.

In other embodiments the number of quantized values in the look-up table may be less or equal to a number of different sum values of the individual quantization values for the sequence of pulses. Embodiments may enable a reduction of the look-up table compared to the above, which considers all possible combinations of the individual quantized values. Embodiments may allow utilization of the same quantization value for multiple different sequences of individual quantized values or pulses, where the quantization value may be determined based on a selection criterion, e.g. based on error minimization, efficiency, etc. Embodiments may enable enhanced processing efficiency since the look-up table might not comprise quantization values which would lead to a low efficiency or performance. The processing module may be configured to determine a quantized value for all combinations of individual quantization values for the sequence of pulses having a different sum value.

The processing module may be configured to determine quantized values or information related to improvement values for the look-up table for combinations of individual quantization values for the sequence for which a phase difference is less than a predetermined phase threshold, for which an amplitude difference is less than a predetermined amplitude threshold, for sequences for which all individual quantization values but the last individual quantization value for a sequence are equal, and/or using a Trellis graph for combinations of individual quantization values. Embodiments may allow for different reduction concepts for the look-up table to further limited determination or adaptation efforts.

Embodiments further provide an apparatus to determine a look-up table to assign a quantized value to a sequence of pulses. The sequence of pulses is based on a corrected baseband signal and the corrected baseband signal is based on a former quantized value. A quantized value relates to information related to a sequence of pulses for a pulse width modulated signal. The apparatus comprises a processing module to determine individual quantization values for the pulses in the sequence of pulses and to determine the quantized value based on the individual quantization values for the pulses of the sequence. Embodiments may enable determination of multiple pulses for selection based on a quantization value.

Embodiments further provide a method for providing information related to a pulse width modulated signal for an amplifier. The method comprises inputting a baseband signal. The method further comprises determining an integrated value based on a corrected baseband signal, and determining a quantized value based on the integrated value. The corrected baseband signal is based on a former quantized value. The method further comprises selecting information on multiple pulses based on the quantized value, and providing information on the multiple selected pulses as information related to the pulse width modulated signal.

Embodiments further provide a method for determining a look-up table to assign a quantized value to a sequence of pulses. The sequence of pulses is based on a corrected baseband signal. The corrected baseband signal is based on a former quantized value, and a quantized value indicates information on the sequence of pulses for a pulse width modulated signal. The method comprises determining individual quantization values for the pulses of the sequence of pulses. The method further comprises determining the quantized value based on the individual quantization values for the pulses of the sequence.

Embodiments further provide a computer program having a program code for performing at least one of the above methods, when the computer program is executed on a computer, a processor, or a programmable hardware component. A further embodiment is a computer readable storage medium storing instructions which, when executed by a computer, processor, or programmable hardware component, cause the computer to implement one of the methods described herein.

Brief description of the figures

Some other features or aspects will be described using the following non-limiting embodiments of apparatuses or methods or computer programs or computer program products by way of example only, and with reference to the accompanying figures, in which:

Fig. 1 illustrates a block diagram of an embodiment of an apparatus to provide information related to a pulse width modulated signal for an amplifier;

Fig. 2 illustrates a block diagram of an embodiment of an apparatus to determine a look-up

table to assign a quantized value to a sequence of pulses;

Fig. 3 shows a block diagram of an embodiment in a DSM;

Fig. 4 shows a constellation diagram for an embodiment;

Fig. 5 depicts a time line of a combination of two pulses in an embodiment;

Fig. 6 depicts an exemplary 3-dimensional plot for 4 different amplitude values, 8 different phase positions and an under-sampling rate of 3 in an embodiment;

Fig. 7 shows a projection of the 3-dimensional representation of Fig. 6 onto the complex plane;

Fig. 8 depicts two constellation diagrams in an embodiment;

Fig. 9 shows an impact on a power density spectrum in an embodiment;

Fig. 10 depicts narrow band simulation results obtained for embodiments;

Fig. 11 depicts wideband simulation results obtained for embodiments;

Fig. 12 shows a block diagram of a flow chart of an embodiment of a method for providing information related to a pulse width modulated signal for an amplifier; and

Fig. 13 shows a block diagram of a flow chart of an embodiment of a method for determining a look-up table to assign a quantized value to a sequence of pulses.

Description of Embodiments

Various example embodiments will now be described more fully with reference to the accompanying drawings in which some example embodiments are illustrated. In the figures, the thicknesses of lines, layers or regions may be exaggerated for clarity.

Accordingly, while example embodiments are capable of various modifications and alternative forms, embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like or similar elements throughout the description of the figures.

As used herein, the term, "or" refers to a non-exclusive or, unless otherwise indicated (e.g., "or else" or "or in the alternative"). Furthermore, as used herein, words used to describe a relationship between elements should be broadly construed to include a direct relationship or the presence of intervening elements unless otherwise indicated. For example, when an element is referred to as being "connected" or "coupled" to another element, the element may be directly connected or coupled to the other element or intervening elements may be present. In contrast, when an element is referred to as being "directly connected" or "directly coupled" to another element, there are no intervening elements present. Similarly, words such as "between", "adjacent", and the like should be interpreted in a like fashion.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" or "including," when used herein, specify the presence of stated features, integers, steps, operations, elements or components, but do not preclude the presence or addition of one or more other features, integers, steps, operations, elements, components or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

In the following some embodiments of apparatuses, methods and computer programs to provide information related to a pulse width modulated signal and to determine a look-up table will be described. Embodiments further provide an amplifier or a transceiver, such as for a base station transceiver or a mobile transceiver of a mobile communication system, comprising such respective apparatuses.

In general, the mobile communication system may, for example, correspond to one of the Third Generation Partnership Project (3GPP)-standardized mobile communication networks, where the term mobile communication system is used synonymously to mobile communication network. The mobile or wireless communication system may correspond to, for example, a Long-Term Evolution (LTE), an LTE-Advanced (LTE-A), High Speed Packet Access (HSPA), a Universal Mobile Telecommunication System (UMTS) or a UMTS Terrestrial Radio Access Network (UTRAN), an evolved-UTRAN (e-UTRAN), a Global System for Mobile communication (GSM) or Enhanced Data rates for GSM Evolution (EDGE) network, a GSM/EDGE Radio Access Network (GERAN), or mobile communication networks with different standards, for example, a Worldwide Inter-operability for Microwave Access (WIMAX) network IEEE 802.16 or Wireless Local Area Network (WLAN) IEEE 802.11, generally an Orthogonal Frequency Division Multiple Access (OFDMA) network, a Time Division Multiple Access (TDMA) network, a Code Division Multiple Access (CDMA) network, a Wideband-CDMA (WCDMA) network, a Frequency Division Multiple Access (FDMA) network, a Spatial Division Multiple Access (SDMA) network, etc.

A base station transceiver can be operable to communicate with one or more active mobile transceivers and a base station transceiver can be located in or adjacent to a coverage area of another base station transceiver, e.g. a macro cell base station transceiver or small cell base station transceiver. Hence, embodiments may provide a mobile communication system comprising one or more mobile transceivers and one or more base station transceivers, wherein the base station transceivers may establish macro cells or small cells, as e.g. pico-, metro-, or femto cells. A mobile transceiver may correspond to a smartphone, a cell phone, user equipment, radio equipment, a mobile, a mobile station, a laptop, a notebook, a personal computer, a Personal Digital Assistant (PDA), a Universal Serial Bus (USB) -stick, a car, a mobile relay transceiver for D2D communication, etc. A mobile transceiver may also be referred to as User Equipment (UE) or mobile in line with the 3GPP terminology.

A base station transceiver can be located in the fixed or stationary part of the network or system. A base station transceiver may correspond to a remote radio head, a transmission point, an access point, radio equipment, a macro cell, a small cell, a micro cell, a femto cell, a metro cell etc. A base station transceiver may correspond to a base station understood as a logical concept of a node/entity terminating a radio bearer or connectivity over the air interface between a terminal/mobile transceiver and a radio access network. A base station transceiver can be a wireless interface of a wired network, which enables transmission of radio signals to a UE or mobile transceiver. Such a radio signal may comply with radio signals as, for example, standardized by 3GPP or, generally, in line with one or more of the above listed systems. Thus, a base station transceiver may correspond to a NodeB, an eNodeB, a Base Transceiver Station (BTS), an access point, a remote radio head, a transmission point, a relay transceiver etc., which may be further subdivided in a remote unit and a central unit.

A mobile transceiver can be associated, camped on, or registered with a base station transceiver or cell. The term cell refers to a coverage area of radio services provided by a base station transceiver, e.g. a NodeB (NB), an eNodeB (eNB), a remote radio head, a transmission point, etc. A base station transceiver may operate one or more cells on one or more frequency layers, in some embodiments a cell may correspond to a sector. For example, sectors can be achieved using sector antennas, which provide a characteristic for covering an angular section around a remote unit or base station transceiver. In some embodiments, a base station transceiver may, for example, operate three or six cells covering sectors of 120° (in case of three cells), 60° (in case of six cells) respectively. A base station transceiver may operate multiple sectorized antennas. In the following a cell may represent an according base station transceiver generating the cell or, likewise, a base station transceiver may represent a cell the base station transceiver generates. Embodiments may be based on the finding that a determination of quantized values, for example, for a switched mode amplifier in a transceiver, may be reduced regarding the speed of the feedback loop by using lookup-tables, which may be pre-calculated or determined or adaptive, which may correspond to multiple output cycles and/or branches. At the same time the performance of the system may be improved or optimized for given operation conditions due to higher flexibility. A transceiver may be implemented as any means for transceiving, i.e. receiving and/or transmitting etc., one or more transceiver units, one or more transceiver devices and it may comprise typical receiver and/or transmitter components, such as one or more elements of the group of one or more Low-Noise Amplifiers (LNAs), one or more Power Amplifiers (PAs), one or more filters or filter circuitry, one or more diplexers, one or more duplexers, one or more Analog-to-Digital converters (A/D), one or more Digital-to-Analog converters (D/A), one or more modulators or demodulators, one or more mixers, one or more antennas, etc.

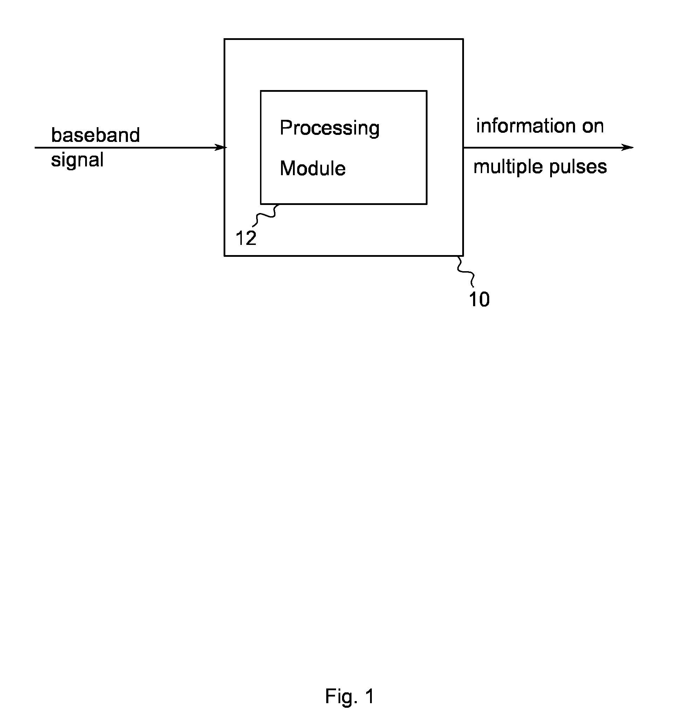

Fig. 1 illustrates a block diagram of an embodiment of an apparatus 10 to provide information related to a pulse width modulated signal for an amplifier. The apparatus 10 comprises an input for a baseband signal. The apparatus 10 further comprises a processing module 12 to determine an integrated value based on a corrected baseband signal and to determine a quantized value based on the integrated value. The corrected baseband signal is based on a former quantized value. The processing module 12 is configured to select information on multiple pulses based on the quantized value and to provide information on the multiple selected pulses as information related to the pulse width modulated signal.

In embodiments the processing module 12 may be implemented using one or more processing units, one or more processing devices, any means for processing, any means for controlling, such as a processor, a computer or a programmable hardware component being operable with accordingly adapted software. In other words, the described functions of the processing module 12 may as well be implemented in software, which is then executed on one or more programmable hardware components. Such hardware components may comprise a general purpose processor, a Digital Signal Processor (DSP), a microcontroller, etc. Correspondingly, components of the processing module 12 may as well be implemented in software, which is executed on one or more of the above hardware components.

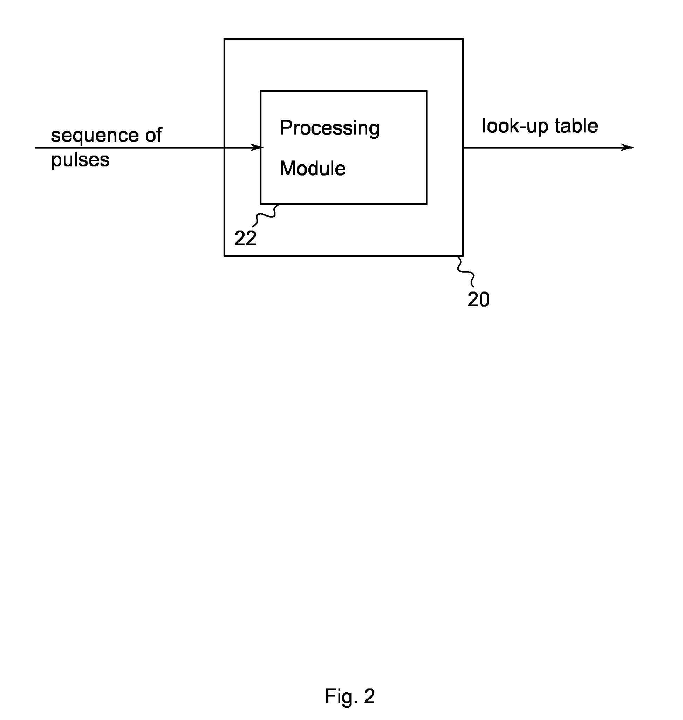

Fig. 2 illustrates a block diagram of an embodiment of an apparatus 20 to determine a look-up table to assign a quantized value to a sequence of pulses or one or more integrated values. The sequence of pulses or one or more integrated values is based on a corrected baseband signal. The corrected baseband signal is based on a former quantized value, and a quantized value relates to information related to a sequence of pulses for a pulse width modulated signal. The apparatus 20 comprises a processing module 22 to determine individual quantization values for the pulses or one or more integrated values of the sequence of pulses or one or more integrated values and to determine the quantized value based on the individual quantization values for the pulses or integrated values of the sequence. In embodiments the described signals may be represented by time and/or value discrete or continuous values or functions. In embodiments the apparatuses 10 and 20 may be equivalent and used in a transceiver or to compute quantized values for a transceiver. When implemented in a transceiver embodiments may allow for adaptive determination, calculation or updating of quantized values. In the following the processing modules 12, 22 may hence also be considered equivalent such that features described for one may as well be implemented in the other and vice versa.

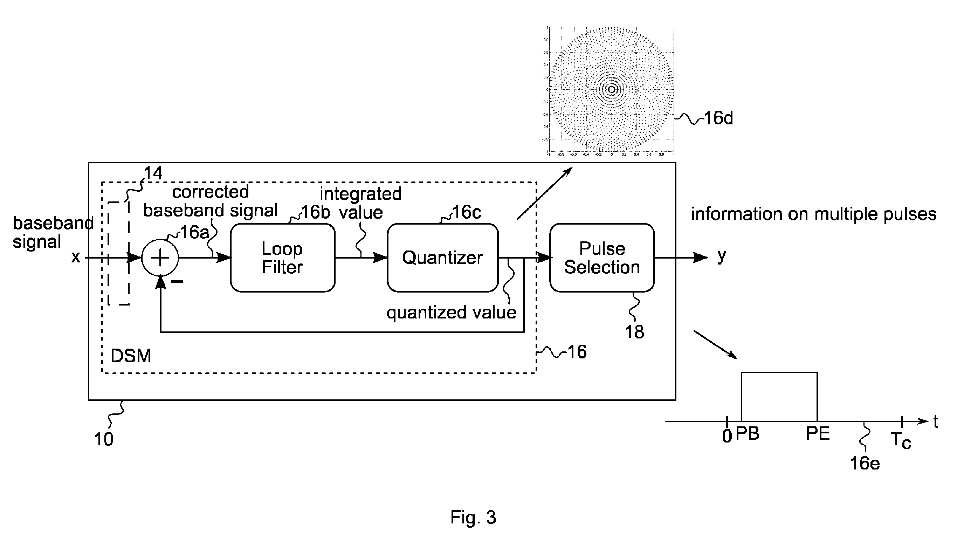

Fig. 3 shows a block diagram of an embodiment in a DSM and a PWM. In Fig. 3 the baseband signal X is input into an embodiment of the apparatus 10. The input signal is assumed to have a BandWidth (BW) that is sampled with a frequency of $f_{s,in}$. Normally $f_{s,in} > 2*BW$. As will be detailed subsequently, there are several possibilities in embodiments for the sample rate of the baseband signal. In some embodiments the sampling theorem is just met and hence the sample rate at which the samples of the baseband signal are available at the input may be just above the double bandwidth of the baseband signal represented by said samples. In some embodiments, the base band signal may be oversampled and hence a sampling rate may be significantly higher, e.g. by a factor of 10, 50, 100, or even more, than the double bandwidth. In some embodiments the apparatus 10, 20 may even comprise an over sampler 14, which is shown in Fig. 3 as an optional component, and which may adapt the sampling rate of the baseband signal. For example, the sampling rate may be adapted to a subsequent processing speed, e.g. a clock rate within the feedback loop as described in the following.

As further shown in Fig. 3, there is a DSM 16 running at $f_{dsm}$ . Normally $f_{dsm}$ >>*BW.* In a conventional DSM and Radio Frequency (RF)-PWM combination, $f_{dsm} = f_c$ where $f_c$ corresponds to a carrier frequency of the respective radio or communication system. At the output of the DSM 16 a pulse pattern is selected by pulse selection module 18, which is comprised in the apparatus 10, 20 in the present embodiment. Each pulse pattern may represent an amplitude and phase value.

As shown by Fig. 3 the DSM 16 comprises a summation module 16a, which determines a corrected baseband value based on the input baseband signal and a quantized value, which is fed back from the output of the DSM 16 and which corresponds to a former determined quantized value or a quantized value which was determined in an earlier processing cycle. The summation module 16a determines a difference between said quantized value from an earlier cycle and the input baseband signal, which results in the corrected baseband signal. The corrected baseband signal is then input into a loop filter 16b, which may be implemented as an integrator, and which determines the integrated values based on the corrected baseband signal. The integrated values are then input into quantizer 16c, which determines quantized values based on the integrated values. The quantized values are then input into the pulse selection module 18 and fed back to the summation module 16a. It is to be noted that digital signal processing may be applied in the components displayed in Fig. 3. In some embodiments the quantized value may not be directly input in the pulse selection 18 but any value that is based on the quantized value and which allows selecting multiple pulses.

The sample rates may, however, differ among the components. At the very output there is a signal *y*, which represents the output PWM signal comprising pulses at the rate of the radio signal, or which carries information related to the multiple pulses as described above. The pulses themselves may still be represented by time discrete values at a sample rate, which may be above the double radio frequency. Embodiments may provide the advantage that the sampling rate relations between the baseband signal, the quantized values and the pulse rate may become more flexible. As already indicated above, a plurality of quantized values may be determined as a time discrete signal at a first (sample) rate and the information on the multiple pulses may indicate pulses at a second (pulse) rate. The first rate is lower than the second rate as multiple pulses are generated per quantized value. With respect to the input baseband signal the optional over sampler 14 has already been described. In some embodiments the baseband signal may correspond to a time discrete signal at a third (sample) rate, where the third rate is lower than the first rate and the second rate.

As further shown in Fig. 3 the quantized values at the output of the quantizer 16c can be summarized in a constellation diagram 16d. The constellation diagram shows, as an example, a complex plane with possible quantization values having different amplitudes and phases. The pulse selection module 18 may then select the multiple pulses based on the quantized value from the constellation diagram 16d, which is exemplified by the pulse shown in time (*t*) diagram 16e, in which PB denotes the beginning of the pulse, PE denotes the end of the pulse, and $T_c$ denotes the cycle duration, which may correspond to the period duration of the carries signal $T_c = 1/f_c$.

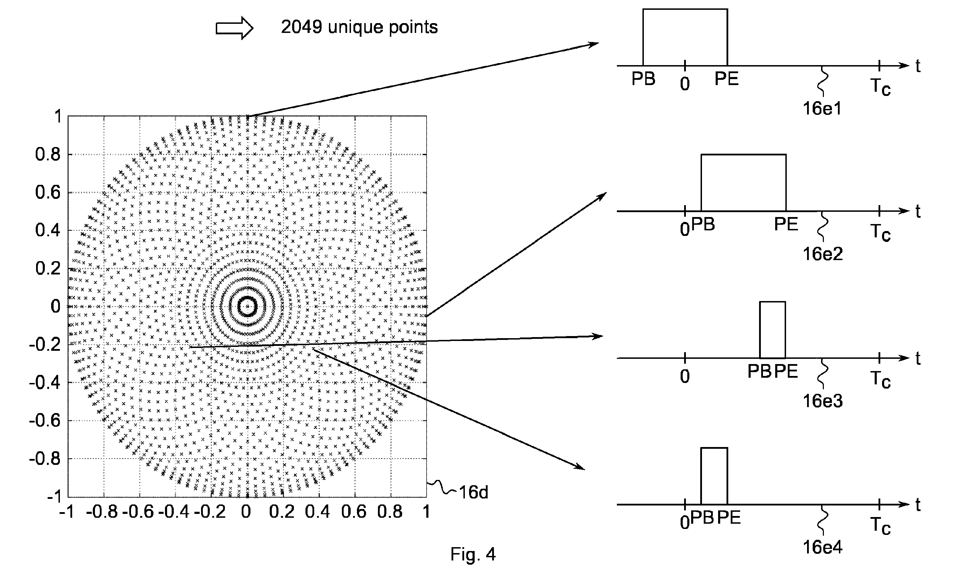

Fig. 4 shows a constellation diagram for an embodiment, which comprises 2049 (unique) quantization values or points. Each point represents a pulse pattern, for which four diagrams 16e1, 16e2, 16e3, and 16e4 are depicted in Fig. 4 in line with the pulse diagram 16e of Fig. 3. It is to be noted that Fig. 4 depicts single pulses and embodiments may assign multiple of these single pulses per quantized value. As can be seen from Fig. 4 the amplitude of the quantized value may influence the pulse duration and the phase of the quantized value may influence the beginning and/or end of a pulse. A quantized value representing a single pulse may also be referred to as individual quantization value as will be further detailed subsequently.

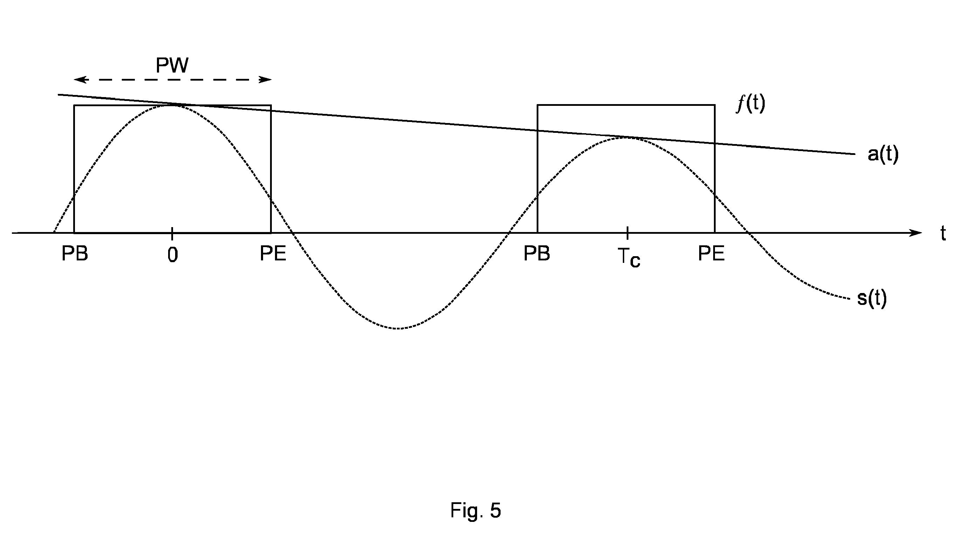

Fig. 5 depicts a time line of a combination of two pulses as they may be selected by pulse selection module 18 based on a quantized value as a sequence of two pulses. Fig. 5 further illustrates the carrier signal *s(t)* and its envelope *a(t)* shows how the amplitudes are influenced by the respective pulses. The pulse forms are given by *f(t).*

The amplitude and phase of the selected pattern (complex value *a*) can be calculated by computing the complex Fourier component at the wanted frequency (carrier frequency). These complex values result in a quantization matrix Q. Here and in the following these values are calculated for binary signals without loss of generality. The signal can, for example, also be ternary or any multi-level signal. In the following

*f(t)* is the pulse pattern in the time domain,

$P_1$ is the signal power at the carrier frequency $f_c$,

$P_{tot}$ is the total power of the pulse pattern *f(t)*,

$\eta_c$ is the coding efficiency,

$\eta_{c,dis}$ is the coding efficiency in the discrete case based on the discrete Fourier transformation (DFT),
$N$ is the number of discrete samples per carrier period $T_c$. Hence,

$$a = \frac{1}{T_c} \int_0^{T_c} f(t) e^{(-2\pi \, j f_c t)} dt \quad ,$$

$$P_1 = \frac{|2a|^2}{2} \quad ,$$

$$P_{tot} = \frac{1}{T_c} \int_0^{T_c} f(t)^2 \, dt \quad ,$$

$$\eta_c = \frac{P_1}{P_{tot}} \quad ,$$

and

$$\eta_{c,dis} = \frac{2}{N} \frac{\left| \sum_{n=0}^{N-1} f[n] e^{(-2\pi \, jn/N)} \right|^2}{\sum_{n=0}^{N-1} f[n]^2} \quad .$$

So for each single pulse pattern there is one corresponding complex value, also referred to as individual quantization value, representing the complex amplitude at the carrier frequency. Now, for each sample at the input at the DSM one output can be selected, in embodiments the multiple pulse patterns can be selected for combined quantized values. The rule of selection can differ based on the individual goal. Most commonly, one may try to minimize the Mean Square Error (MSE) between the actual output of an amplifier based on the pulse patterns and a desired output. This selection leads to the corresponding pulse generation. In Fig. 3 a complex first order DSM 16 is described as an embodiment. This structure may be replaced or complemented in various ways without changing the operation principle in other embodiments. In some embodiments the order of the DSM 16 may be increased or the weightings of the paths may be changed to optimize or improve the noise shaping and thereby improve the signal quality.

In line with Fig. 3, the selected point or quantized value is fed back and subtracted from the next signal sample at the input, from the same sample dependent on the sample rate relations in the embodiments. In the next stage (loop filter 16b) the error is integrated. Based on this value and the quantization matrix, the next complex sample or quantized value is fed back and at the same time the corresponding multiple pulses are sent at the output. Embodiments are based on the finding that it is possible to apply this principle for longer periods of time, based on the above described system and equations. Instead of only looking at the impact of one pulse embodiments consider multiple pulses in a sequence and calculate their corresponding complex values. This allows generating a quantization matrix not for a single pulse (respectively the integration over 1 carrier period) but for any number of pulses.

The processing module 12, 22 may then be configured to assign a quantized value to a sequence of integrated values or pulses, where the sequence of integrated values or pulses may be based on a sequence of corrected baseband values. It is to be noted that the rate at which quantization values are determined is lower than a pulse rate as one quantization value may form the basis for selecting multiple or a sequence of pulses. In some embodiments the DSM 16 may be operated at a rate which is lower than the pulse rate. In some embodiments the quantizer 16c may be operated at a lower rate than the pulse rate, while the loop filter 16b may be operated at a higher rate than the quantizer 16c. The quantizer 16c may, in some embodiments, provide a quantized value based on one or more integrated values.

The sequence of corrected baseband values may be corrected based on the same quantized value. An Under-Sampling Rate (USR) can be defined as the number of pulses (carrier periods) summarized by a single quantization point or value. The calculation of the complex value for multiple pulses may be considered the same as the summation of the individual complex values for each pulse.

This may, in some embodiments, lead to an increase of the quantization matrix in size. Some of the points might not be unique, because different combinations of pulses lead to the same summarized quantization point. Now the quantization matrix may be improved or optimized and reduced in size by deleting duplicates. Which point to delete can be decided on different rules. One way is to select the most efficient point. The efficiency can be calculated in different ways and may depend on the whole system and its performance goals and specifications. One way is to calculate the wanted signal power to the total output power. For example, $M$ is the under-sampling rate USR and the $a_m$ is the complex value of each pulse of a longer segment, to which it can also be referred to as individual quantization value, where an individual quantization value represents one integrated value in a sequence of integrated values, one pulse in a sequence of pulses, respectively. $N * M$ may be considered as the total number of discrete points of a segment corresponding to $USR * T_c$. Then

$$\sum_{n=0}^{N*M-1} f[n] e^{(-2\pi jn/N)} = \sum_{m=0}^{M-1} a_m.$$

In an embodiment the most efficient point of the quantization matrix may be chosen and if there are two points with the same efficiency, one can, for example, be picked randomly.

The processing module 12, 22 may hence be configured to determine, based on an optimization criterion, one quantized value for all different combinations of individual quantization values for the sequence of pulses having the same sum value. The processing module 12, 22 may be configured to determine a quantized value for all different combinations of individual quantization values for the sequence of pulses having a different sum value.

The total number of quantization points (No_of_Q) can be calculated by the number of possible amplitudes (No_of_Amps), the number of possible phase positions (No_of_phs) and the under-sampling rate (USR):

$$No\_of\_Q = (No\_of\_phs * No\_of\_Amps + 1)^{\wedge}USR.$$

In other words the number of quantization points may correspond to the number of possible quantization points for an individual quantization value (No_of_phs*No_of_Amps+1) to the power of the length of the sequence (USR). In some embodiments the processing module 12, 22 is configured to obtain the quantized value based on a look-up table, wherein the look-up table assigns quantized values to different sequences of multiple pulses. The processing module 12, 22 may be configured to determine the look-up table based on a number of pulses in a sequence of pulses, e.g. based on USR, based on a number of different amplitude values (No_of_Amps) distinguished per individual quantization value in the sequence of pulses, and based on a number of different phase values (No_of_phs) distinguished per individual quantization value in the sequence of integrated values or pulses.

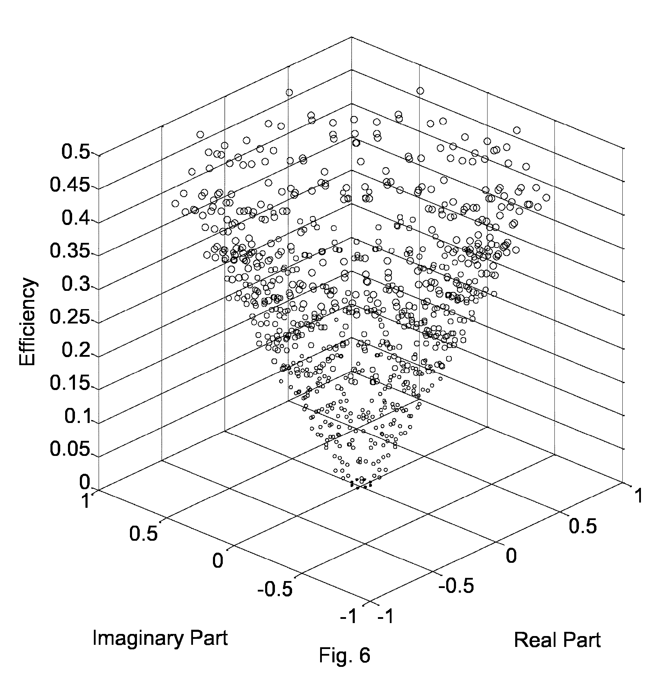

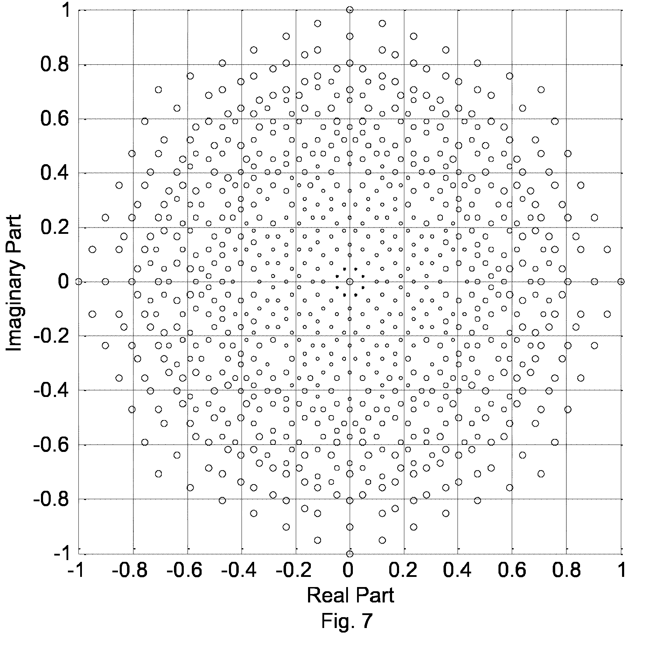

The number of permutations of individual quantization values may be based on an increased product of the number of different amplitude values distinguished for individual quantization values and the number of different phase values distinguished for individual quantization values, wherein the product is increased by one (for the origin point of the complex plane as will be shown in Figs. 6 and 7 in line with the above equation) and wherein the increased product is raised to the power of the number of pulses in the sequence of pulses, e.g. USR. The number of quantized values in the look-up table may be less or equal to a number of different sum values of the individual quantization values for the sequence of pulses.

Fig. 6 depicts an exemplary plot for 4 different amplitude values, 8 different phase positions and an under-sampling rate of 3. Fig. 6 shows a 3-dimensional plot with the complex plane as basis and the coding efficiency to the top. Fig. 6 shows the number of different complex sum values which result from combining three individual quantization values for a sequence of three subsequent integrated values or pulses. Fig. 7 shows the projection of the 3-dimensional representation of Fig. 6 onto the complex plane. The coding efficiency may increase with increasing distance from the origin of the complex plane, i.e. with increasing magnitude of the quantized value.

In some embodiments the processing module 12, 22 may be configured to update the look-up table and/or to determine information related to improvement values for the look-up table based on an output signal of the amplifier. An adaptive updating mechanism may be implemented in embodiments which allows for adaptation of the quantized values or for determination for correction values/improvement values for the quantized values. For example, at the output of an amplifier amplitude and/or phase values may be measured or determined based on the output signal at the carrier frequency, its envelope, respectively.

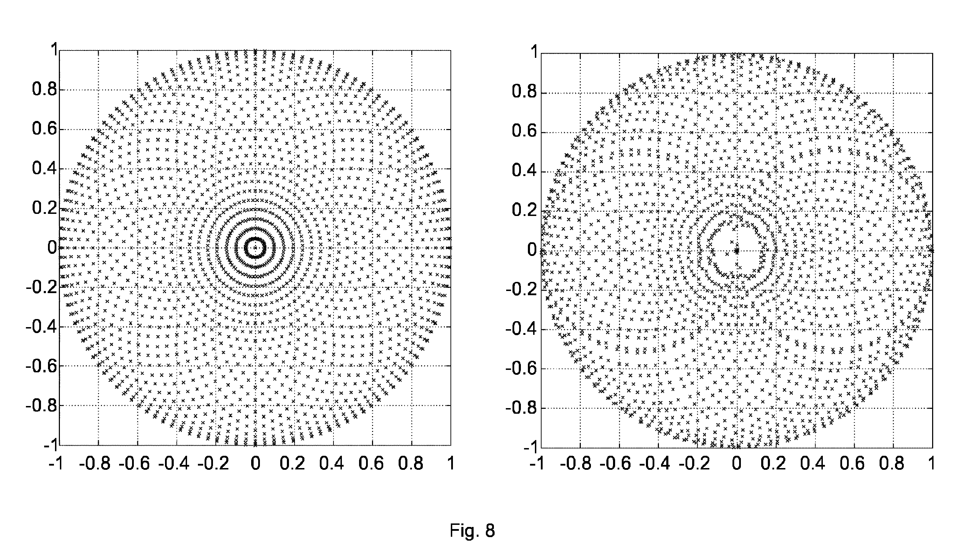

These values can be compared to the quantized value and determined differences may be used to update the quantized values or to determine improvement values, which may then be used to correct or improve the quantized values in the look-up table or which may be used in the pulse selection process to change, improve, or error-compensate pulses selected for certain quantization values. Fig. 8 depicts two constellation diagrams in an embodiment. Fig. 8 shows an ideal constellation diagram on the left and a distorted constellation diagram on the right. As can be seen when comparing the two constellation diagrams distortion may take place, which can be evoked by various effects, for example, by non-ideal or non-linear amplifier characteristics, temperature influences, influences due to aging of components, etc. As mentioned above in embodiments, the distorted quantized values may be measured or determined and taken into account for subsequent pulse selection, be it by correcting or updating the quantized values or by modifying the already existing quantized values or pulse selection.

In some embodiments, the number of quantized values can become very high for a system with many steps per carrier period. Instead of calculating all possible points first and then a selection of the best points may be carried out, in some embodiments a suboptimal solution with less effort may be implemented. The number of quantized values in the look-up table may then be less than a number of permutations of individual quantization values, wherein an individual quantization value represents one pulse in the sequence of pulses. Four possible ways are described in the following embodiment, where it is to be noted that further concepts may as well be implemented in embodiments. A complex quantization point may also be seen as a vector with an amplitude and phase.

The processing module 12, 22 may be configured to determine quantized values or information related to improvement values for the look-up table for combinations of individual quantization values for the sequence for which a phase difference is less than a predetermined phase threshold. In some embodiments the processing module 12, 22 may only allow for low phase differences between the phases of the individual pulses. As it turned out for some embodiments, the most efficient points are those, which are mostly "constructive" meaning that they point in the same direction or that their phases differ less than a certain threshold. In some embodiments the processing module 12, 22 may be configured to determine quantized values or information related to improvement values for the look-up table for combinations of individual quantization values for the sequence for which an amplitude difference is less than a predetermined amplitude threshold. Similarly to the phase differences, some embodiments may consider combinations with similar amplitudes of the individual pulses (consequently same pulse width), which were also found to lead to efficient combinations.

In further embodiments the above phase and amplitude evaluations may be combined. Combinations of individual quantized values differing by less than a certain phase threshold and differing by less than a certain amplitude threshold may be considered. The processing module 12, 22 may be configured to determine quantized values or information related to improvement values for the look-up table for combinations of individual quantization values for the sequence for which all individual quantization values but the last individual quantization value for a sequence are equal. In some embodiments the multiple selected pulses may comprise two or more repetitions of the same pulse, a segment of pulses, i.e. a series of multiple pulses may, for example, be composed by repeating USR-1 times the same vector or quantized value and the last element may differ. In yet further embodiments the processing module 12, 22 may be configured to determine quantized values or information related to improvement values for the look-up table for combinations of individual quantization values for the sequence using a Trellis graph for combinations of individual quantization values. In embodiments it is also possible to build the possible quantization matrix by following a Trellis code or diagram. For example, the lengths of the individual vectors (amplitudes) are the weights for the respective path. When reaching the same point, the path with the lowest weight continues, while all others can be terminated. For example, a path metric may correspond to a sum of individual quantization values, their magnitudes, respectively, and paths with the lowest magnitudes may succeed.

As said before the described concept can also be applied in embodiments using multi-level signals. For example, these signals can be generated using multiple branches. The characteristics of the individual branches can be accounted for while generating the quantization matrix and selecting the best or at least promising points. As such the amplification/weighting of the branches and the effects of combining, filtering, amplification and distortion, etc., can be used to optimize the quantization matrix. Thus the look-up table may also function as a pre-distortion in some embodiments.

Embodiments may enable a reduction of the speed of the DSM loop by the factor

$$USR : f_{dsm} = f_c / USR .$$

Various rules may be applied in embodiments to select quantization points depending on the application. With the knowledge of multiple cycles the performance may be improved or even optimized.

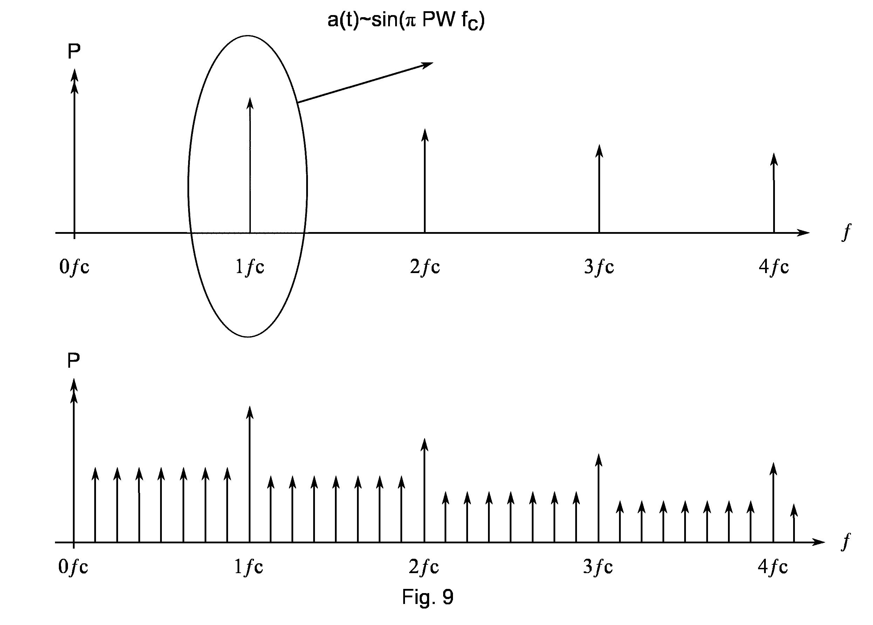

Fig. 9 shows the impact on the power density spectrum in an embodiment. Fig. 9 shows the conventional spectrum in which the pulses evoke spectral power densities at integer multiples of the carrier frequency $f_c$ at the top. Instead of a spectrum mainly consisting of spurs at multiples of $f_c$ (top view graph in Fig. 9), the output spectrum in an embodiment as shown at the bottom of Fig. 9 has more spurs at all multiples of $f_c$ / $USR$. The spurs at fractions of $f_c$ are much lower than the ones at multiples of $f_c$. In the following, details will be shown from an embodiment with the following parameters:

$$f_{dsm} = 122.88 MHz \qquad ,$$

$$f_c = 8 * 122.88 MHz = 983.04 MHz \qquad ,$$

$$USR = 8 \qquad ,$$

$$N = 8 \qquad .$$

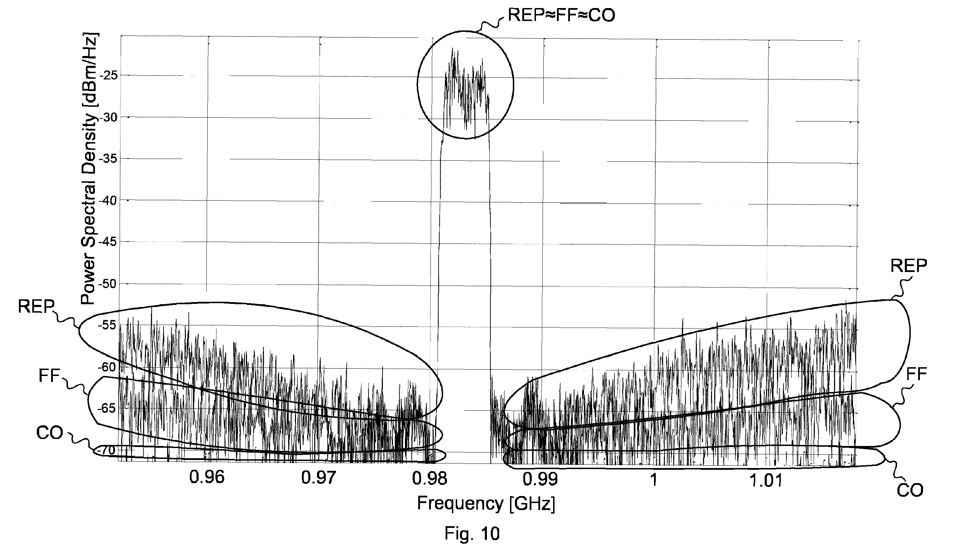

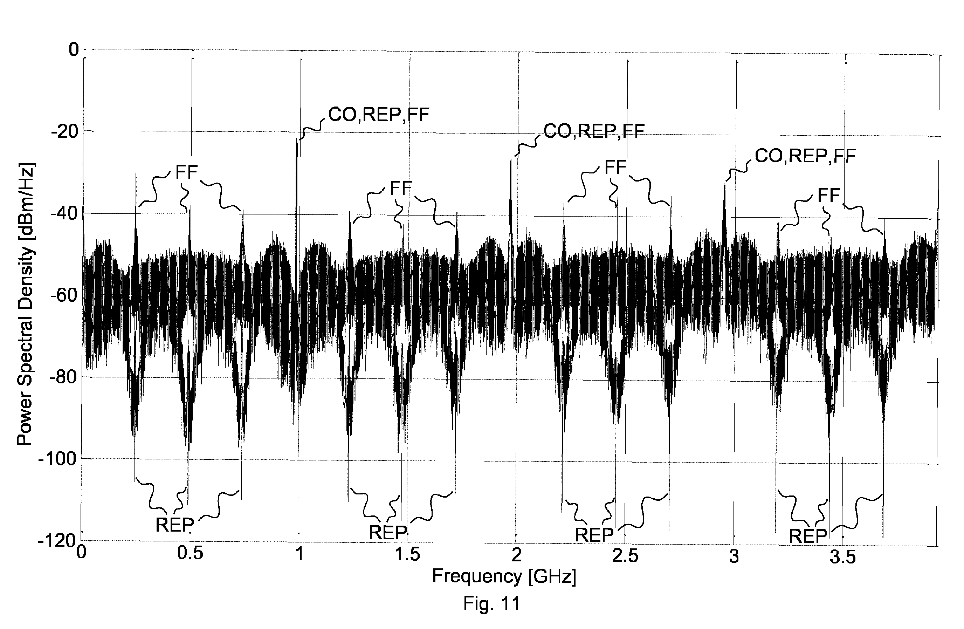

In this embodiment there are 8 possible pulse positions per carrier period. Three cases will be compared with the help of Figs. 10 and 11. Both Figs. depict simulation results for three cases, where Fig. 10 shows a narrow band spectrum and Fig. 11 shows the corresponding wideband spectrum. In a first embodiment (sections referenced with REP in Figs. 10 and 11) with USR=8, only one pulse is used for the whole segment, it is repeated 8 times. In a second embodiment (sections referenced with FF in Figs. 10 and 11) USR=8 is used at full freedom of pulse combinations, e.g. 8 different pulses. Sections referenced with CO in Figs. 10 and 11 refer to conventional DSM running at $f_c$ ($f_c = f_{dsm}$).

As one can see from Fig. 10 and 11 embodiments may have impact on the noise shaping characteristics but do not show any significant difference with respect to the inband power density. The conventional approach shows the lowest noise in the sideband, the embodiment with full freedom shows the second lowest sideband noise and the embodiment with the pulse repetition shows the highest sideband noise. Depending on the choice of points embodiments may improve efficiency, inband-linearity or wide-band emissions. In the case of the FF embodiment a slightly better linearity close to the wanted band (Adjacent Channel Power Ratio (ACLR) improved by 3.2dB) is achieved compared to the simple repetition case REP. The wide band noise is also shaped differently. While REP determines notches and spurs at multiples of $f_c$ / $USR$, FF has a broader noise floor but less noise close to the wanted signal (cf. narrow band spectrum depicted in Fig. 10). Embodiments may hence reduce the required complexity and thereby reduce the expenses for technology and/or manufacturing.

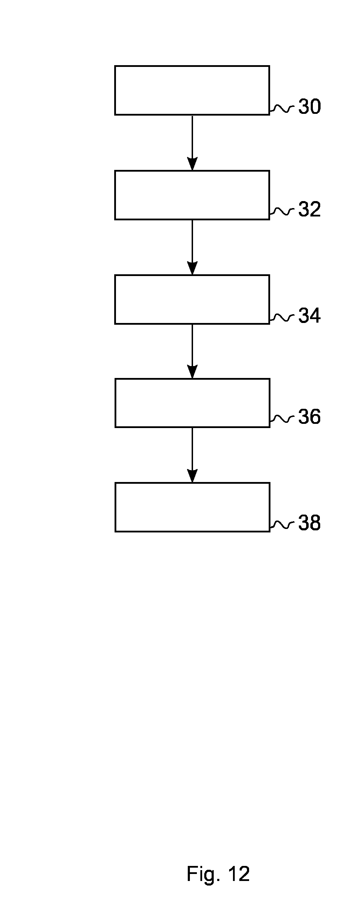

Fig. 12 shows a block diagram of a flow chart of an embodiment of a method for providing information related to a pulse width modulated signal for an amplifier. The method comprises inputting 30 a baseband signal, and determining 32 an integrated value based on a corrected baseband signal. The method further comprises determining 34 a quantized value based on the integrated value. The corrected baseband signal is based on a former quantized value. The method further comprises selecting 36 information on multiple pulses based on the quantized value, and providing 38 information on the multiple selected pulses as information related to the pulse width modulated signal.

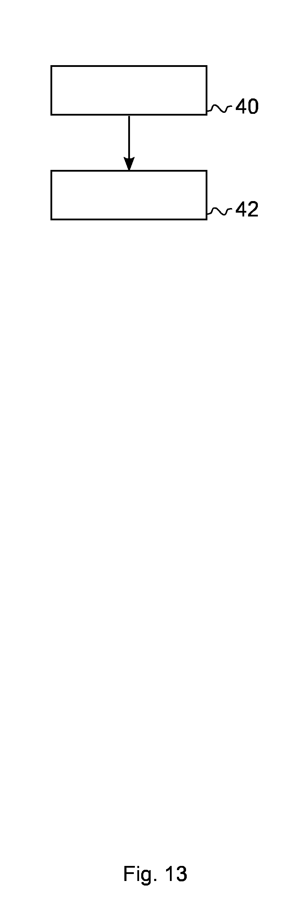

Fig. 13 shows a block diagram of a flow chart of an embodiment of a method for determining a look-up table to assign a quantized value to a sequence of pulses. The sequence of pulses is based on a corrected baseband signal and the corrected baseband signal is based on a former quantized value. A quantized value indicates information on multiple pulses for a pulse width modulated signal. The method comprises determining 40 individual quantization values for the pulses of the sequence of pulses. The method further comprises determining 42 the quantized value based on the individual quantization values for the pulses of the sequence.

Some embodiments comprise a digital control circuit installed within the apparatus for performing the method. Such a digital control circuit, e.g. a Digital Signal Processor (DSP), needs to be programmed accordingly. Hence, yet further embodiments also provide a computer program having a program code for performing embodiments of the method, when the computer program is executed on a computer, a digital processor, or a programmable hardware component.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions where said instructions perform some or all of the steps of methods described herein. The program storage devices may be, e.g., digital memories, magnetic storage media such as magnetic disks and magnetic tapes, hard drives, or optically readable digital data storage media. The embodiments are also intended to cover computers programmed to perform said steps of methods described herein or (field) programmable logic arrays ((F)PLAs) or (field) programmable gate arrays ((F)PGAs), programmed to perform said steps of the above-described methods.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for ..." (performing a certain function) shall be understood as functional blocks comprising circuitry that is adapted for performing or to perform a certain function, respectively. Hence, a "means for s.th." may as well be understood as a "means being adapted or suited for s.th.". A means being adapted for performing a certain function does, hence, not imply that such means necessarily is performing said function (at a given time instant).

The functions of the various elements shown in the Figures, including any functional blocks labeled as "means", "means for controlling", "means for transmitting", "means for receiving", "means for transceiving", "means for processing", etc., may be provided through the use of dedicated hardware, such as "a controller", "a transmitter", "a receiver", "a transceiver", "a processor", etc. as well as hardware capable of executing software in association with appropriate software. Moreover, any entity described herein as "means", may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional or custom, may also be included. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

**Claims**

1. An apparatus (10) to provide information related to a pulse width modulated signal for an amplifier, the apparatus (10) comprising

an input for a baseband signal; and

a processing module (12) to determine an integrated value based on a corrected baseband signal and to determine a quantized value based on the integrated value, wherein the corrected baseband signal is based on a former quantized value, wherein the processing module (12) is configured to select information on multiple pulses based on the quantized value and to provide information on the multiple selected pulses as information related to the pulse width modulated signal.

2. The apparatus (10) of claim 1, wherein a plurality of quantized values is determined as a time discrete signal at a first rate and wherein the information on the multiple pulses indicates pulses at a second rate, wherein the first rate is lower than the second rate.

3. The apparatus (10) of claim 2, wherein the baseband signal corresponds to a time discrete signal at a third rate, wherein the third rate is lower than the first rate and the second rate.

4. The apparatus (10) of claim 1, wherein the processing module (12) is configured to assign a quantized value to a sequence of one or more integrated values or pulses, wherein the sequence of integrated values or pulses is based on a sequence of one or more corrected baseband values, and wherein the sequence of one or more corrected baseband values is corrected based on the same quantized value, and/or wherein the multiple selected pulses comprise two or more repetitions of the same pulse.

5. The apparatus (10) of claim 1, wherein the processing module (12) is configured to obtain the quantized value based on a look-up table, wherein the look-up table assigns quantized values to different sequences of multiple pulses.

6. The apparatus (10) of claim 5, wherein the processing module (12) is configured to determine the look-up table based on a number of individual quantization values for a sequence of multiple pulses, wherein an individual quantization value represents a pulse in the sequence of multiple pulses, based on a number of different amplitude values distinguished per individual quantization value in the sequence, and based on a number of different phase values distinguished per individual quantization value in the sequence.

7. The apparatus (10) of claim 6, wherein the processing module (12) is configured to update the look-up table and/or to determine information related to improvement values for the look-up table based on an output signal of the amplifier.

8. The apparatus (10) of claim 6, wherein the number of quantized values in the look-up table is less than a number of permutations of individual quantization values, wherein the number of permutations of individual quantization values is based on an increased product of the number of different amplitude values distinguished for individual quantization values and the number of different phase values distinguished for individual quantization values, wherein the product is increased by one and wherein the increased product is raised to the power of the number of pulses in the sequence of pulses.

9. The apparatus (10) of claim 7, wherein the number of quantized values in the look-up table is less or equal to a number of different sum values of the individual quantization values for the sequence of pulses.

10. The apparatus (10) of claim 8, wherein the processing module (12) is configured to determine a quantized value for all combinations of individual quantization values for the sequence of pulses having a different sum value.

11. The apparatus (10) of claim 7, wherein the processing module (12) is configured to determine quantized values or information related to improvement values for the look-up table for combinations of individual quantization values for the sequence for which a phase difference is less than a predetermined phase threshold, for which an amplitude difference is less than a predetermined amplitude threshold, for sequences for which all individual quantization values but the last individual quantization value for a sequence are equal, and/or using a Trellis graph for combinations of individual quantization values.

12. An apparatus (20) to determine a look-up table to assign a quantized value to a sequence of pulses, wherein the sequence of pulses is based on a corrected baseband signal, wherein the corrected baseband signal is based on a former quantized value, and wherein a quantized value relates to information related to the sequence of pulses for a pulse width modulated signal, the apparatus (20) comprising

a processing module (22) to determine individual quantization values for the pulses in the sequence of pulses and to determine the quantized value based on the individual quantization values for the pulses of the sequence.

**13.** A method for providing information related to a pulse width modulated signal for an amplifier, the method comprising inputting (30) a baseband signal;
determining (32) an integrated value based on a corrected baseband signal; determining (34) a quantized value based on the integrated value, wherein the corrected baseband signal is based on a former quantized value;
selecting (36) information on multiple pulses based on the quantized value; and providing (38) information on the multiple selected pulses as information related to the pulse width modulated signal.

**14.** A method for determining a look-up table to assign a quantized value to a sequence of pulses, wherein the sequence of pulses is based on a corrected baseband signal, wherein the corrected baseband signal is based on a former quantized value, and wherein a quantized value indicates information on the sequence of pulses for a pulse width modulated signal, the method comprising determining (40) individual quantization values for the pulses of the sequence of pulses; and
determining (42) the quantized value based on the individual quantization values for the pulses of the sequence.

**15.** A computer program having a program code for performing at least one of the methods of claims 13 and 14, when the computer program is executed on a computer, a processor, or a programmable hardware component.

**Amended claims in accordance with Rule 137(2) EPC.**

**1.** An apparatus (10) to provide information related to a pulse width modulated signal for an amplifier, the apparatus (10) comprising
an input for a baseband signal; and
a processing module (12) to determine an integrated value based on a corrected baseband signal and to determine a quantized value based on the integrated value, wherein the corrected baseband signal is based on a former quantized value, wherein the processing module (12) is configured to select information on a sequence of pulses based on the quantized value and to provide information on the sequence of the selected pulses as information related to the pulse width modulated signal.

**2.** The apparatus (10) of claim 1, wherein a plurality of quantized values is determined as a time discrete signal at a first rate and wherein the information on the sequence of pulses indicates pulses at a second rate, wherein the first rate is lower than the second rate.

**3.** The apparatus (10) of claim 2, wherein the baseband signal corresponds to a time discrete signal at a third rate, wherein the third rate is lower than the first rate and the second rate.

**4.** The apparatus (10) of claim 1, wherein the processing module (12) is configured to assign the quantized value to a sequence of one or more integrated values or to the sequence of pulses, wherein the sequence of integrated values or pulses is based on a sequence of one or more corrected baseband values, and wherein the sequence of one or more corrected baseband values is corrected based on the same quantized value, and/or wherein the sequence of selected pulses comprises two or more repetitions of the same pulse.

**5.** The apparatus (10) of claim 1, wherein the processing module (12) is configured to obtain the quantized value based on a look-up table, wherein the look-up table assigns quantized values to different sequences of pulses.

**6.** The apparatus (10) of claim 5, wherein the processing module (12) is configured to determine the look-up table based on a number of individual quantization values for the sequence of pulses, wherein an individual quantization value represents a pulse in the sequence of pulses, based on a number of different amplitude values distinguished per individual quantization value in the sequence, and based on a number of different phase values distinguished per individual quantization value in the sequence.

**7.** The apparatus (10) of claim 6, wherein the processing module (12) is configured to update the look-up table and/or to determine information related to improvement values for the look-up table based on an output signal of the amplifier.

**8.** The apparatus (10) of claim 6, wherein the number of quantized values in the look-up table is less than a number of permutations of individual quantization values, wherein the number of permutations of individual quantization values is based on an increased product of the number of different amplitude values distinguished for individual quantization values and the number of different phase values distinguished for individual quantization values, wherein the product is increased by one and wherein the increased product is raised to the power of the number of pulses in the sequence of pulses.

9. The apparatus (10) of claim 7, wherein the number of quantized values in the look-up table is less or equal to a number of different sum values of the individual quantization values for the sequence of pulses.

10. The apparatus (10) of claim 8, wherein the processing module (12) is configured to determine a quantized value for all combinations of individual quantization values for the sequence of pulses having a different sum value.

11. The apparatus (10) of claim 7, wherein the processing module (12) is configured to determine quantized values or information related to improvement values for the look-up table for combinations of individual quantization values for the sequence for which a phase difference is less than a predetermined phase threshold, for which an amplitude difference is less than a predetermined amplitude threshold, for sequences for which all individual quantization values but the last individual quantization value for a sequence are equal, and/or using a Trellis graph for combinations of individual quantization values.

12. An apparatus (20) to determine a look-up table to assign a quantized value to a sequence of pulses, wherein the sequence of pulses is based on a corrected baseband signal, wherein the corrected baseband signal is based on a former quantized value, and wherein a quantized value relates to information related to the sequence of pulses for a pulse width modulated signal, the apparatus (20) comprising
a processing module (22) to determine individual quantization values for the pulses in the sequence of pulses and to determine the quantized value based on the individual quantization values for the pulses of the sequence.

13. A method for providing information related to a pulse width modulated signal for an amplifier, the method comprising
inputting (30) a baseband signal;
determining (32) an integrated value based on a corrected baseband signal; determining (34) a quantized value based on the integrated value, wherein the corrected baseband signal is based on a former quantized value;
selecting (36) information on a sequence of pulses based on the quantized value; and
providing (38) information on the sequence of the selected pulses as information related to the pulse width modulated signal.

14. A method for determining a look-up table to assign a quantized value to a sequence of pulses, wherein the sequence of pulses is based on a corrected baseband signal, wherein the corrected baseband signal is based on a former quantized value, and wherein a quantized value indicates information on the sequence of pulses for a pulse width modulated signal, the method comprising
determining (40) individual quantization values for the pulses of the sequence of pulses; and
determining (42) the quantized value based on the individual quantization values for the pulses of the sequence.

15. A computer program having a program code for performing at least one of the methods of claims 13 and 14, when the computer program is executed on a computer, a processor, or a programmable hardware component.

baseband
signal

Processing

Module

information on

multiple pulses

12

10

Fig. 1

sequence of
pulses

Processing

Module

look-up table

22

20

Fig. 2

Fig. 3

Fig. 4

Fig. 5

Fig. 6

Fig. 7

Real Part

Imaginary Part

Fig. 8

EP 2 985 910 A1

EP 2 985 910 A1

$a(t) \sim \sin(\pi \ PW \ f_c)$

P

0$f$c   1$f$c   2$f$c   3$f$c   4$f$c   $f$

P

0$f$c   1$f$c   2$f$c   3$f$c   4$f$c   $f$

Fig. 9

Fig. 10

Fig. 11

~ 30

~ 32

~ 34

~ 36

~ 38

Fig. 12

Fig. 13

Europäisches
Patentamt
European
Patent Office
Office européen
des brevets

## EUROPEAN SEARCH REPORT

Application Number

EP 14 30 6277

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 533 421 A1 (ALCATEL LUCENT [FR]) 12 December 2012 (2012-12-12) * paragraph [0045] - paragraph [0052]; figures 3-6 * | 1,5,13, 15 | INV. H03F3/189 H03F3/217 |
| X | US 2013/241663 A1 (DING LEI [US] ET AL) 19 September 2013 (2013-09-19) * paragraph [0035] - paragraph [0037]; figures 4-6 * | 1,2,5, 13,15 | |
| X | US 2009/167431 A1 (GUILHERME DAVID FILIPE CORREIA [PT] ET AL) 2 July 2009 (2009-07-02) * paragraph [0037] - paragraph [0041]; figures 1,2,3 * | 1,5,13, 15 | |
| X | EP 2 728 746 A1 (ALCATEL LUCENT [FR]) 7 May 2014 (2014-05-07) * the whole document * | 1,13 | |
| X | US 2005/264350 A1 (LEE JAE-WOOK [KR] ET AL) 1 December 2005 (2005-12-01) * the whole document * | 1,13 | TECHNICAL FIELDS SEARCHED (IPC) |
| X | WO 2008/051127 A1 (ERICSSON TELEFON AB L M [SE]; REXBERG LEONARD [SE]; MALMQVIST HAAKAN []) 2 May 2008 (2008-05-02) * the whole document * | 1,13 | H03F |

-/--

~~The present search report has been drawn up for all claims~~

| Place of search | Date of completion of the search | Examiner |
|---|---|---|
| Munich | 12 February 2015 | Kurzbauer, Werner |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt
European
Patent Office
Office européen
des brevets

# EUROPEAN SEARCH REPORT

Application Number

EP 14 30 6277

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | THIEL B T ET AL: "System architecture of an all-digital GHz transmitter using pulse-width/position-modulation for switching-mode PAs", MICROWAVE CONFERENCE, 2009. APMC 2009. ASIA PACIFIC, IEEE, PISCATAWAY, NJ, USA, 7 December 2009 (2009-12-07), pages 2340-2343, XP031614255, ISBN: 978-1-4244-2801-4 * the whole document * | 1-11,13, 15 | |
| A | MOHAMMAD MOJTABA EBRAHIMI ET AL: "Delta-Sigma-Based Transmitters: Advantages and Disadvantages", IEEE MICROWAVE MAGAZINE, IEEESERVICE CENTER, PISCATAWAY, NJ, US, vol. 14, no. 1, 1 January 2013 (2013-01-01), pages 68-78, XP011491633, ISSN: 1527-3342, DOI: 10.1109/MMM.2012.2226541 * the whole document * | 1-11,13, 15 | |

TECHNICAL FIELDS
SEARCHED (IPC)

~~The present search report has been drawn up for all claims~~

| Place of search | Date of completion of the search | Examiner |
|---|---|---|
| Munich | 12 February 2015 | Kurzbauer, Werner |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

Application Number

EP 14 30 6277

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-11, 13, 15

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 14 30 6277

The Search Division considers that the present European patent application does not comply with the requirements of unity of invention and relates to several inventions or groups of inventions, namely:

1. claims: 1-11, 13, 15

   An apparatus (and a corresponding method) to provide information related to a pulse width modulated signal for an amplifier, the apparatus comprising a processing module which is configured to select information on multiple pulses based on the quantized value and to provide information on the multiple selected pulses as information related to the pulse width modulated signal.
   ---

2. claims: 12, 14

   An apparatus (and corresponding method) to determine a look-up table to assign a quantized value to a sequence of pulses, wherein the sequence of pulses is based on a corrected baseband signal, wherein the corrected baseband signal is based on a former quantized value, and wherein a quantized value relates to information related to the sequence of pulses for a pulse width modulated signal, the apparatus comprising a processing module to determine individual quantization values for the pulses in the sequence of pulses and to determine the quantized value based on the individual quantization values for the pulses of the sequence.
   ---

## ANNEX TO THE EUROPEAN SEARCH REPORT
## ON EUROPEAN PATENT APPLICATION NO.

EP 14 30 6277

This annex lists the patent family members relating to the patent documents cited in the above-mentioned European search report.
The members are as contained in the European Patent Office EDP file on
The European Patent Office is in no way liable for these particulars which are merely given for the purpose of information.

12-02-2015

| Patent document cited in search report | | Publication date | Patent family member(s) | | Publication date |
|---|---|---|---|---|---|
| EP 2533421 | A1 | 12-12-2012 | NONE | | |
| US 2013241663 | A1 | 19-09-2013 | US 2013241663 A1 | | 19-09-2013 |
| | | | WO 2013138645 A1 | | 19-09-2013 |
| US 2009167431 | A1 | 02-07-2009 | US 2009167431 A1 | | 02-07-2009 |
| | | | US 2010201445 A1 | | 12-08-2010 |
| EP 2728746 | A1 | 07-05-2014 | NONE | | |
| US 2005264350 | A1 | 01-12-2005 | JP 2005341568 A | | 08-12-2005 |
| | | | KR 20050112649 A | | 01-12-2005 |
| | | | US 2005264350 A1 | | 01-12-2005 |
| WO 2008051127 | A1 | 02-05-2008 | EP 2087586 A1 | | 12-08-2009 |
| | | | JP 5006403 B2 | | 22-08-2012 |
| | | | JP 2010507965 A | | 11-03-2010 |
| | | | US 2010097153 A1 | | 22-04-2010 |
| | | | WO 2008051127 A1 | | 02-05-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014079862 A1
- EP 2330734 A1

- EP 2403136 B1

**Non-patent literature cited in the description**

- **BASSOO ; VANDANA.** A digital up-conversion architecture for future high efficiency wireless base stations. *PhD thesis thesis,* 2010